## Europäisches Patentamt
## European Patent Office
## Office européen des brevets

(19)

(11) Veröffentlichungsnummer: **0 017 921**
**B1**

(12) **EUROPÄISCHE PATENTSCHRIFT**

(45) Veröffentlichungstag der Patentschrift: 29.06.83

(21) Anmeldenummer: **80101932.4**

(22) Anmeldetag: **10.04.80**

(51) Int. Cl.³: **G 03 B 41/00, B 25 J 7/00, H 01 L 41/08.**

(54) Piezoelektrische Antriebsanordnung, insbesondere für Fokussiersysteme.

(30) Priorität: 14.04.79 DE 2915313

(43) Veröffentlichungstag der Anmeldung:
29.10.80 Patentblatt 80/22

(45) Bekanntmachung des Hinweises auf die Patenterteilung:
29.06.83 Patentblatt 83/26

(84) Benannte Vertragsstaaten:
AT BE CH DE FR GB IT LI LU NL SE

(56) Entgegenhaltungen:
FR - A - 2 184 344.
FR - A - 2 223 865
FR - A - 2 262 866
FR - A - 2 330 030
US - A - 3 154 700
US - A - 3 233 749
US - A - 3 899 697

(73) Patentinhaber: DISCOVISION ASSOCIATES
P.O. Box 6600 3300 Hyland Avenue
Costa Mesa California 92626 (US)

(72) Erfinder: Rösch, Hans, Dr.
Römersteinstrasse 4
D-7410 Reutlingen 17 (DE)
Erfinder: Kallmeyer, Michael
Sperberweg 24
D-7030 Böblingen (DE)
Erfinder: Scheuing, Claus
Gmünder Strasse 11
D-7073 Lorch (DE)
Erfinder: Solf, Bernhard
Balinger Strasse 5
D-7032 Sindelfingen 6 (DE)

(74) Vertreter: Fleuchaus, Leo, Dipl.-Ing. et al,
Melchiorstrasse 42
D-8000 München 71 (DE)

Courier Press, Leamington Spa, England.

Piezoelektrische Antriebsanordnung, insbesondere für Fokussiersysteme

Die Erfindung betrifft eine piezoelektrische Antriebsanordnung der im Oberbegriff des Anspruches 1 angegebenen Art. Diese piezoelektrische Antriebsanordnung soll insbesondere in automatischen Fokussiersystemen oder allgemeinen Ablenk- und Auslenksystemen verwendet werden.

Eine piezoelektrische Antriebsanordnung dieser Art ist durch die US—A—3 233 749 für einen Mikromanipulator bekannt. Dieser Mikromanipulator umfaßt zwei Stäbe aus einer Vielzahl von hintereinander angeordneten Piezokristallelementen, deren Längen nach Potenzen von 2 gestaffelt sind. Die einzelnen Piezokristallelemente sind nicht mit wechselnder Polarität ansteuerbar. Da lediglich eine An- und Abschaltung von der Antriebsspannung erfolgt, ergeben sich hysteresebedingte Ungenauigkeiten bei der Auslenkung.

Durch die US—A—3 899 697 ist es bekannt daß Kristallelemente unter Ausnutzung der ferroelektrischen Polarisation des Kristalls in bistabile Endlagen umschaltbar sind, indem positive oder negative Spannungsimpulse angelegt werden. Wegen der breiten angestrebten Hystereseschleife wire die Endlage auch beibehalten, wenn die Steuerspannung auf Null züruckgeht. Die angegebene impulsförmige Ansteuerung ist bei Piezokirstallelementen nicht verwendbar, wenn der Einfluß von Hystereseeffekten ausgeschaltet werden soll.

Aus der deutschen Offenlegungsschrift 25 24 854 ist eine piezoelektrische Antriebsanordnung für einen Mosaikdruckknopf bekannt, welche aus zwei flachen, lang gestreckten piezoelektrischen Wandlern besteht, die unlösbar mineinander verbunden und schichtförmig übereinander angeordnet sind. Beide Wandler haben eine gemeinsame mit einem Steuerpotential beaufschlagt Steuerelektrode. Die jeweils angeordneten Gegenelektroden liegen an konstantem Potential.

Des weiteren ist aus der deutschen Offenlegungsschrift 25 24 893 ein Mosaikdruckknopf mit piezoelektrischen Antriebselementen bekannt, welche sich nach Beaufschalgung der Elektroden mit einem sich sprunghaft ändernden elektrischen Feld von einer großen ortsfesten Masse abstoßen und infolge ihrer Massenträgheit auf einem Aufzeichnungsträger einen Abdruck bewirken.

In der deutschen Offenlegungsschrift 24 26 331 ist ein piezoelektrisches Lichtstrahablenkelement beschrieben, welches einen um eine Achse drehbaren Spiegel aufweist. Diese Achse ist zwischen den Enden zweier piezoelektrischer Platten gelagert. Bei einer gegenläufigen Längenänderung der beiden Platten infolge Anlegen elektrischer Spannungen rollt die Achse längs der Oberflächen der Platten ab.

In der deutschen Offenlegungsschrift 27 10 935 ist ein Matrixdrucker mit piezoelektrisch getriebenen Drucknadeln beschrieben. Bei diesem Drucker ist eine Knickfeder vorgesehen, die bei einer elektrisch gesteuerten Ausdehnung einer Piezokristallanordnung auslenkbar ist. Diese Piezokristallanordnung besteht aus in Polarisationsrichtung hintereinandergeschalteten Piezokristallelementen mit jeweils zwei Polflächen. Die Piezokristallelemente sind so angeordnet, daß die Polfächen gleicher Polarisationspolarität aufeinander ausgerichtet sind. Alle Polfächen mit positiver Polarisationspolarität sind mit dem negativen Pol einer Steuerspannungsquelle verbunden, während die anderen Polflächen mit negativer Polarisationspolarität mit dem positiven Pol dieser Steuerspannungsquelle verbunden sind. An jedem Piezokristallelement liegt somit die gleiche Steuerspannung an. Die Teilausdehnungen der einzelnen Piezokristallelemente addieren einander zu einem gewünschten Hub bei einer entsprechenden Ansteuerung der Piezokristallelemente mit Steuerpulsen.

Des weiteren sind eine Vielzahl von Fokussiersystemen bekannt, in denen eine Optik zur Aufrechterhaltung der Fokussierung z. B. eines Lichtstrahles auf einen bestimmten Punkt nachgeführt werden muß. Derartige Einrichtungen sind z. B. in den deutschen Offenlegungsschriften 27 53 436, 20 12 995 und 26 56 730 beschrieben.

Des weiteren ist aus der Publikation "Disk" (Tentative B-900) der Robert Bosch GmbH, Geschäftsbereich Fernsehanlagen, Darmstadt/Deutschland, ein "Professional Optical Video Disk System" beschrieben. Dabei wird zur Herstellung von Video-Bildplatten Information mit Hilfe eines Laserstrahles auf die Videoplatte geschrieben. Da sich geringfügige Verfälschungen im Videobild nicht störend auswirken, sind auch keine extrem hohen Auflösungen an das Fokussiersystem zur Fokussierung des Laserstrahles erforderlich. Die Fokussieranordnung ist deshalb mit Hilfe leichter und somit auch billiger Linsen (keine Qualitätslinsen) und mit Hilfe eines für diese leichten Linsen geeigneten Tauchspulenantriebes realisierbar.

Der Erfindung liegt die Aufgabe zugrunde, eine piezoelektrische Antriebsanordnung und Steuerung für eine sicher gesteuerte Auslenkung mit hohem Auflösungsvermögen bzw. feinen Steuerinkrementen zu schaffen, welche insbesondere zur Objektivnachführung eines Fokussiersystems mit hoher Auflösung einsetzbar ist.

Für extrem hohe Auflösung bei einer Datenaufzeichnung mit einem Laserstrahl auf einen rotierenden Informationsträger ist eine äußerst genaue Fokussierung des Laserstrahls erforderlich. Hierfür wären die Fokussieranordnungen mit leichten Linsen und dafür geeigneten Tauchspulenantrieben nicht mehr zu verwenden; zur Erreichung einer höheren Auflösung müßten bessere, d.h. schwerere Linsen verwendet werden, die sich jedoch nicht mehr problem frei durch Tauchspulenantriebe bewegen ließen.

Die Fokussier-Tiefenschärfe bekannter Nachführungssysteme liegt in der Größenordnung von ±1 μm, während die Tiefenschärfe für eine erwünschte Datenaufzeichnung mit höchster Auflösung bei einem bedeutend kleineren Wert liegt (±0,1 μm).

Die Aufgabe zur Schaffung eines piezoelektrischen Antriebselementes für gesteuerte Hubbewegungen höchster Auflösung und höchster möglicher Geschwindigkeit (nur begrenzt durch die mechanische Leitkonstante des Stellgliedes) wird durch die im kennzeichnenden Teil des Anspruchs 1 genannten Maßnahmen gelöst.

Die geforderte hohe Auflösung wird unter anderem dadurch erreicht, daß die Steuerung der Ausdehnung der Piezokristallelemente hysteresefrei und nach Potenzen von 2 gestaffelten Stufen erfolgt.

Die hohe Geschwindigkeit wird durch Wegfall der durch die Hysteresis bedingten susätzlichen Totzeit erreicht. Das Anlegen eines Feldes zur Erreichung einer gewünschten Ausdehnung und die Zurücknahme des Feldes auf den Wert O, was bei bisher bekannten Anordnungen üblich war, ist von einem an sich bekannten Hystereseeffekt piezoelektrischer Materialien begleitet. Feinste Abstufungen in der Bewegung zunehmender und/oder abnehmender Auslenkungen wären nur mit einem analogen Ausregeln der elastischen Hysterese möglich. Da jedoch in einem analogen Regelsystem eine Hysterese eine Tot-Zeit verursacht, würde eine analoge Regelung um die aus der Hysterese folgende Totzeit langsamer werden. Übliche analoge Regelsysteme, die konvertionelle Piezokristallelemente zur Nachfürung benutzen, sind für die beschriebene Anwendung zu langsam (Zeitkonstante ca. 5 bis 10 ms, d.h. eine Nachführfrequenz von 100 bis 200 Hz). Ein Tauchspulenantrieb für eine bessere, d.h. schwerere Linse würde versagen.

Vorteilhafte Weiterbildungen der Erfindung sind den Unteransprüchen zu entnehmen. Die Erfingung wird anhand von Zeichnungen dargestellt und ist im folgenden näher beschrieben. Es zeigen.

Fig. 1 eine schematische Darstellung dreier in Reihe angeordneter Piezokristallelemente, die elektrisch separat ansteuerbar sind und deren Einzelausdehnungen sich zu einer Gesamtausdehnung addieren.

Fig. 2 eine schematische Darstellung einer Hystereseschleife für die Ausdehnung eines einzelnen Piezokristallelements in Abhängigkeit von der Steuerfeldstärke.

Fig. 3 eine schematische Darstellung der Ansteuerung eines einzelnen Piezokristallelementes über Treiberschaltungen un einen Inverter.

Fign. 4A und 4B eine schematische Darstellung eines einzelnen Piezokristallelementes zur Festlegung seiner Arbeitspunkte mit einem positiven elektrischen und einem negativen elektrischen Feld,

Fig. 5 eine schematische Darstellung eines Ausführungsbeispieles einer piezoelektrischen Antriebsanordnung, welche aus einer Vielzahl von piezoelektrischen Ringen besteht, welche durch Glasringe voneinander getrennt sind.

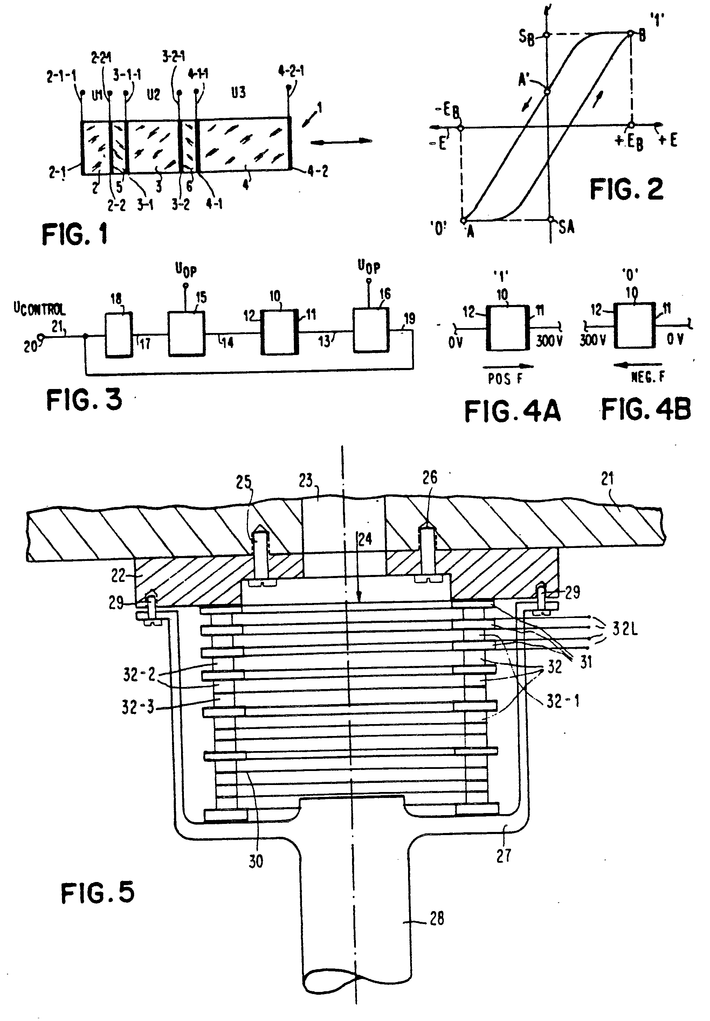

In Fig. 1 ist eine vereinfachte Darstellung einer piezoelektrischen Antriebsanordnung 1 gezeigt. Diese Anordnung besteht aus drei hintereinanderliegenden Piezokristallelementen 2, 3, 4, die voneinander durch isolierende Elemente 5, 6 getrennt sind. Jedes der Piezokristallelemente 2, 3, 4 ist mit metallisierten Polflächen versehen. Die isolierenden Elemente 5, 6 sind aus Glas, welches an den den Polanschlußflächen der Piezokristallelemente zugewandten Seiten ebenfalls metallisiert ist. Die metallisierten Polflächen der Piezokristallelemente, die metallisierten Seitenflächen der isolierenden Elemente und die Kontaktlamellen für die elektrischen Leitungen sind mit 2-2, 3-1, 3-2, 4-1 bezeichnet; die Polanschlußflächen und Kontaktlamellen an den Endseiten dier Piezoelektrischen Antriebsanordnung 1 mit 2-1 und 4-2.

Sämtliche Teile 2, 5, 3, 6, 4 der Anordnung 1 sind miteinander verklebt. Als Kleber wird ein elektrisch leitender Kleber vorzugsweise verwendet. Beim Anlegen einer entsprechenden Steuerspannung erfährt das Piezokristallelement eine Längenänderung in Pfeilrichtung. So kann z. B. die Steuerspannung $U_1$ über die Leitungen 2-1-1 und 2-2-1 an die Polanschlußflächen 2-1 und 2-2 des Piezokristallelementes 2 angelegt werden. Entsprechendes gilt für die Steuerspannung $U_2$, die über die Leitungen 3-1-1 und 3-2-1 den Polanschlußflächen 3-1 und 3-2 des Piezokristallelementes 3 zugeführt wird bzw. für die Steuerspannung $U_3$, die über die Leitungen 4-1-1 und 4-2-1 an die Polanschlußflächen 4-1 und 4-2 des Piezokristallelementes 4 gelegt wird. Beim Anlegen der einzelnen Steuerspannungen an die Piezokristallelemente werden im folgenden die Längenänderungen in Richtung des elektrischen Feldes betrachtet. Da die einzelnen Piezokristallelemente hintereinander angeordnet sind. addieren sich ihre Längenänderungen. Die durch Anlegen der Steuerspannungen $U_1$, $U_2$, $U_3$ hervorgerufene Gesamtlängenänderung der Anordnung 1 soll jeweils ein bestimmtes Maß erreichen. Ausgehend von einer erzielten Auslenkung soll wiederum durch Änderun der Kombination der Steuerspannungen eine neue Auslenkung, welche eine Abnahme oder Zunahme der ursprünglichen Auslenkung darstellt, erreicht werden. In einer einfachen Ausführungsform können die durch die Steuerspannungen $U_1$, $U_2$ und $U_3$ in den Piezokristallelementen 2, 3, 4 hervorgerufenen elektrischen Feldstärken gleich groß sein, wohingegen die Abmessungen dieser Piezokristallelemente in Auslenkrichtung unterschiedlich groß sein können. Auf diese Weise werden bei gleicher elektrischer Feldstärke die Teilauslenkungen der einzelnen Piezokristallelemente unterschiedlich groß sein. Durch entsprechende Kombination der anzusteuernden Piezokristallelemente lassen sich somit unterschiedliche Gesamtausdehnungen erreichen, die sich jeweils aus Addition der Auslenkung der einzelnen Piezokristallelemente ergeben. Bei Annahme eines linearen Zusammenhanges zwischen der elektrischen Feldstärke und der Längenänderung eines Piezokristallelementes kann gemäß Fig. 1 eine Anordung vorgegeben werden, bei der die Abmessungen der einzelnen Piezokristallelemente 2, 3, 4 in Auslenkrichtung nach Potenzen von 2 gestaffelt sind. Das heißt, das Element 3 ist doppelt ($2^1$-fach) so groß wie das Element 2, während das Element 4 viermal ($2^2$-fach) so groß wie das Element 2 ist. Die einzelnen Steuerspannungen $U_1$, $U_2$, $U_3$ verhalten sich zur Erreichung gleicher Feldstärken in den Piezokristallelementen 2, 3, 4 wie 1:2:4. Durch entsprechende Kombination der zu erregenden Piezokristallelemente lassen sich unterschiedliche Gesamtauslenkungen erreichen: die kleinste Längenänderung ergibt sich, wenn nur das Element 2; die größte, wenn alle Elemente 2, 3, 4 erregt sind. Entsprechend der binären Vielfalt von 3 Elementen sind insgesamt $2^3$ verschiedene Gesamtauslenkungswerte möglich. An jedes Piezokristallelement, z. B. 2, kann entweder der positive Wert der Steuerspannung $U_1$ ≙ LOGISCH '1' oder ner negative Wert $-U_1$ ≙ LOGISCH '0' angelegt werden. Dadurch ergibt sich im Piezokristallelement jeweils eine elektrische Feldstärke eintgegengesetzter Richtung. Die Maßnahme ist für digitalisierte Bewegungsabläufe mit hoher Auflösung bedeutsam. Die verhindert ein hysteresebehaftetes Auslenken eines Piezokristallelementes.

Die elastische Hysterese von Piezokristallelementen beim Anlegen einer Steuerspannung ist an sich bekannt. Diese Erscheinung ist darauf zurückzuführen, daß durch das Anlegen einer Steuerspannung an das Piezokristallelement in diesem eine Feldstärke bestimmter Richtung aufgebaut wird und daß nach dem Abschalten dieser Steuerspannung die Längenänderung des Elementes nicht etwa auf Null, sondern auf einen dem punkt A' (slehe Fig. 2) entsprechenden Wert zurückgeht. Mit anderen Worten, beim Fortfall der elektrischen Feldstärke nimmt das Piezokristallelement nicht mehr seine ursprüngliche Abmessung, sondern einen darüber- oder darunterliegenden Wert ein. Dieses Hystereseverhalten macht eine Anwendung entsprechender digitaler piezoelektrischer Antriebsanordnungen im hochauflösenden Auslenkungsbereich unmöglich. Aus diesem Grunde werden für hochauflösende Systeme die Auslenkungsarbeitspunkte eines Piezokristalelementes gemäß der Hysteresedarstellung in Fig. 2 zu A und B festgelegt. Für eine positive Steuerspannung (z. B. $+U_1$) soll sich im Piezokristall eine positive Feldstärke $E_B$ und mit dieser eine Auslenkung $s_B$ einstellen gemäß dem Endpunkt B der Hystereseschleife. Für eine negative Feldstärke $-E_B$ ist eine Verkürzung der ursprünglichen Abmessung des Piezokristallelementes um den Wert $s_A$ gemäß dem anderen Endpunkt A der Hystereseschleife gegeben. Die arbeitspunkte A und B, (denen die Bedeutung einer logischen '1' bzw. '0' gegeben werden) die den Hystereseendpunkten entsprechen, sind einddeutig; der Zustand eines feldfreien Piezokristallelements tritt nicht mehr auf und somit ist auch das nachteilige Hystereseverhalten überwunden. Dieses Prinzip des hysteresefreien Betreibens von piezoelektrischen Antriebsanordnungen gilt auch für andere, nicht dargestellte Anordnungen. So ist es z. B. denkbar, daß einzelne, hintereinander angeordnete Piezokristallelemente mit gleichen Abmessungen in Ausdehnungsrichtung von unterschiedlichen Steuerspannungen, die unterschiedliche elektrische Feldstärken ergeben, beaufschlagt werden. Auch bei einer solchen Anordnung muß gewährleistet sein, daß die Steuerspannung für ein Piezokristallelement einmal einen pisitiven und zum anderen eine negativen Wert gleich großen Absolutbetrages hat, wobei die Steuerspannung groß genug zur Erreichung der Arbeitspunkte A, B der Hysterese sein muß.

Darüber hinaus sind auch Anordnungen denkbar, bei denen sowohl die Abmessungen der einzelnen Piezokristallelemente in Auslenkrichtung als auch die in den einzelnen Piezokristallelementen erzeugten elektrischen Feldstärken variieren können zur Erzeugung vorgegebener Gesamtauslenkungen.

In Fig. 3 ist das Prinzipschaltbild einer Steuerschaltung gezeigt, welche zugleich der Erklärung eines weiteren Vorteiles der hysteresefrei angesteuerten Piezokristallelemente dient. In dieser Darstellung ist das Piezokristallelement 10 und seine beiden Polanschlußflächen mit 12 und 11 bezeichnet. Die Polanschlußfläche 12 ist über eine Leitung 14 mit einer Treiberschaltung 15; die Polanschlußfläche 11 über eine Leitung 13 mit einer zweiten Treiberschaltung 16 verbunden. Diese Treiberschaltungen 15 und 16 dienen dazu, aus beim Auftreten eines logischen Eingangssignales $\pm U_{control}$ (mit der Andeutung einer logischen '1' oder '0'), eine Antriebsspannung $U_{op}$ (z. B. +300 V) oder Masse (=0 V) an die Polanschlußflächen des Piezokristallelementes durchzuschalten.

Im folgenden wird die Auslenkungsdifferenz des Piezokristallelementes 10 betrachtet, die es beim Anlegen einer logischen positiven und negativen Steuerspannung $\pm U_{control}$ erfährt. Für den ersten Fall (gemäß Fig. 4A) wird diese positive Steuerspannung über die Leitung 21 und 19 dem Eingang der Treiberschaltung 15 zugeführt. Daraufhin wird die Spannung $U_{op}$

(z.B.=300 V) von der Treiberschaltung 16 über die Leitung 13 auf die Polanschlußfläche 11 des Piezokristallelementes 10 geschaltet. Durch den Inverter 18 wird die positive Steuerspannung zu einer negativen Steuerspannung negiert, woraufhin die Treiberschaltung 15 über die Leitungen 14 die Polanschlußfläche 12 des Piezokristallelementes 10 an Masse legt. Somit steht eine Spannugn von +300 V über dem Piezokristallelement gemäß Darstellung in Fig. 4A.

Im anderen Falle, nämlich beim Auftreten einer negativen Steuerspannung −U$_{control}$ wird mittels des dem Treiber 15 vorgeschalteten Inverters 18 die Polanschlußfläche 12 des Piezokristallements 10 gemäß Fig. 4B mit 300 V beaufschalgt; während die Polanschluß fläche 11 über die Treiberschaltung 16 auf Masse gelegt wird. Damit ergeben sich die logischen Arbeitspunkte '1' für Fig. 4A und '0' für Fig. 4B, welche denen (B und A) in der Hysteresedarstellung in Fig. 2 entsprechen. Die Differenz der Ausdehnungen des Piezokristallelementes läßt sich somit durch eine Steuerspannung von beispielsweise nur 300 V erreichen. Zur Erlangung der gleichen Ausdehnungsänderung wäre für eine hysteresebehaftete Ansteuerung die doppelte Steuerspannung, nämlich 600 V erforderlich mit entsprechend höheren Anforderungen an Halbleitersteuerschaltungen.

In Fig. 5 ist ein praktisches Ausführungsbeispiel einer piezoelektrischen Antriebsanordnung gezeigt. Diese Anordnung ist mit der Bezugszahl 30 gekennzeichnet. Sie Besteht aus einer Vielzahl von ringförmigen Piezokristallelementen 32, welche dur ringförmige Glaselemente 31 voneinander getrennt sind. Die Kontaktflächen der Piezokristallelemente und der isolierenden Glasringe sind jeweils metallisiert. Für eine einwandfrei Kontaktgabe sind Leitungen auf die Metallisierung der Glaselemente metallisch leitend aufgeklebt. Die Glaselemente stehen über die Piezokristallelemente hervor und gestatten somit einen Zugang zum Aufkleben der Zuführungsleitung. Der Aufbau der piezoelektrischen Anordnung 30 ist so gewählt, daß die Einzelausdehnung eines oder mehrerer zwischen zwei isolierenden Glasringen liegenden Piezokristallelemente einer dualen Staffelung unterliegt. Die Teilausdehnungen können entweder durch Variation der Abmessung der Piezokristallelemente in Auslenkrichtung oder durch Variation der Größe des elektrischen Feldes für die einzelnen Piezokristallelemente erreicht werden. Außerdem ist es auch möglich, zwischen zwei isolierenden Glaselementen mehrere Piezokristallelemente, z. B. 32-2 und 32-3, hintereinander anzuordnen und diese elektrische parallel zur Erreichung einer bestimmten Teilausdehnung anzusteuern. Zur Vereinfachung der Darstellung sind die elektrischen Zuleitungen zur Ansteuerung der einzelnen Piezokristallelemente nur auszugsweise wiedergegeben. Sämtliche Piezokristallelemente und isolierenden Glaselemente sind miteinander fest verklebt. Als Kleber wird ein elektrisch leitender Zweikomponentenkleber verwendet. Die Endflächen der Anordnung 30 sind mit einem elektrisch nicht leitenden Zweikomponenten-Kleber mit den Gehäuseteilen 22 und 27 verbunden. Die Anordnung gemäß Fig. 5 dient der Nachführung eines Objektivs, welches im Raum 28 untergebracht ist, zur Verwendung in automatischen Fokussiersystemen. Die Piezoelektrische Antriebsanordnung 30 ist über einen Flansch 22 mittels zweier Schraubbefestigungen 25 und 26 an eine Gehäusewandung 21 angeflanscht. Die Gehäusewandung 21 sowie der Flansch 22 weisen eine gemeinsame Öffnung 23 auf, durch die ein Lichtstrahl in Pfeilrichtung 24 hindurchtreten kann. Aus Gründen der Sicherheit ist die mit dem einen Ende der Anordnung 30 fest verbundene Obkektivhalterung 27 abgewinkelt und lose hängend mit dem Flansch 22 über Verbindungselemente 29 verbunden. Dadurch ist gewährleistet, daß beim unerwünschten Reißen der Klebverbindung innerhalb der Anordnung 30 dieselbe samt Objektivhalterung nicht herabfallen kann.

Die zuvor beschriebene piezoelektrische Antriebsvorrichtung läßt sich in besonders vorteilhafter Weise in Fokussiersystemen zur Datenaufzeichnung mittels eines Laserstrahles auf eine rotierende Platte benutzen. Bei entsprechend vorgegebener hoher Datendichte muß der Laserstrahl auf die Plattenoberfläche genauestens fokussiert werden. Für diese Fokussierung ist ein Qualitätsobjektive mit relative hohem Gewicht erforderlich. Da der Laserstrahl immer genau auf die Oberfläche der rotierenden Platte fokussiert sein muß, ist bedingt durch Unebenheiten der Platte ein Nachstellen des Objektivs erforderlich. Für hochauflösende Systeme versagen herkömmliche Tauchspulenantriebe. Photoelektrische Anordnungen zur Feststellung von Unebenheiten der Platte sind bekannt und werden deshalb nicht näher beschireben. Derartige Anordnungen liefern ein dem Maß der Abweichung entsprechendes analoges Signal. Dieses Signal wird zum Nachstellen dès Objektivs verwendet, um eine Fokussierung des Laserstrahsl genau auf die Oberfläche des rotierenden Aufzeichnungssträgers zu bewirken. Zur Nachsteuerung des Objektivs wird erfindungsgemäß das zunächst noch analoge Steuersignal digitalisiert. Entsprechend dem Wert dieses digitalisierten Signales werden über einen Decoder (nicht dargestellt) die einzelnen anzusteuernden Piezokristallelemente in einer Weise ausgewählt, daß sich durch Addition ihrer Einzelausdehnungen die Nachstellung des Objektivs ergibt. Da für eine exakte und schnelle (digitale) Nachsteuerung des Objektivs diese ständig in eine Richtung oder entgegengesetzt dazu auf bestimmte Positionswerte nachzüfhren ist, muß diese Nachführung für hochauflösende Systeme hysteresefrei sein. Die Nachsteuerung des Objektivs kann entweder in einer geschlossenen Regelschleife erfolgen; ebensogut ist aber auch eine Nachsteuerung des Objektivs aufgrund vorher gemessener und abgespeicherter Abweichungswerte für eine Plattenumdrehung möglich.

Auch zum Datenlesen von einem mit dem Laserstrahl beschriebenen Aufzeichnungsträger wird ein auf diesen fokussierter Laserstrahl versendet. Das Auslesen der Information erfolgt in herkömmlicher Weise durch Auswertung des unterschiedlichen Transmissionsverhaltens des Strahles bezüglich des Aufzeichnungsträgers.

Ähnlich aufgebaute dual gestufte und digital angesteuerte Piezokristallelemente lassen sich auch für alle anderen Ablenk- und Auslenkverfahren verwenden, bei denen es auf hohe Auflösung, Hysteresefreiheit und maximale Ablenk- bzw. Auslenkgeschwindigkeit ankommt.

Besonders vorteilhaft läßt sich die beschriebene Anordnung in prozessorgesteuerten Positioniersystemen einsetzen (z. B. Meßtischfeinsteuerung mit einer Auflösung eines Bruchteiles der Interferometer-Wellenlänge). Dabei kann durch die digitale Art der Steuerung und Meßwerterfassung eine weitere Analog/ Digitalumsetzung oder umgekehrt entfallen.

**Patentansprüche**

1. Piezoelektrische Antriebsanordnung mit einer Steuerschaltung zur Erzeugung gesteuerter Auslenkungen, bestehend aus einer Mehrzahl mit elektrischen Steuerspannungen separat beaufschlagbaren sowie hintereinander angeordneten Piezokristallelemente, deren Einzelauslenkungen sich addieren, dadurch gekennzeichnet, daß an jedes Piezokristallelement (2, 3, 4; 10) zur Ansteuerung der piezoelektrischen Antriebsanordnung eine digitale Steuerspannung ($\pm U_1$, $\pm U_2$, $\pm U_3$) anlegbar ist, welche von einer kontinuierlich anliegenden Antriebsspannung ($U_{oo}$) abgeleitet ist und deren auf das Piezokristallelement wirkende Polarität ein Decodierer entsprechend einem logischen Eingangssignal ($\pm U_{control}$) festlegt, um das jeweilige Piezokristallelement für eine temporär anhaltende Auslenkung in eine Hystereseendpunkt zu steuern.

2. Antriebsanordnung nach Anspruch 1, dadurch gekennzeichnet, daß der vom logischen Eingangssignal ($U_{control}$) beaufschlagte Decodierer einerseite einen Inverter (18) mit nachgeschalteter erster Treiberstufe (15) und andererseits eine zweite Treiberstufe (16) umfaßt, daß das logische Eingangssignal ($U_{control}$) an den Inverter (18) und die zweite Treiberstufe (16) anlegbar ist, und daß die Polflächen (12, 11) des Piezokristallelementes (10) mit jeweils einer der Treiberstufen (15, 16) verbunden sind, welche je nach Wert des logischen Eingangssignals ($U_{control}$) die Polanschlußflächen des Piezokristallelementes mit Masse bzw. mit der Steuerspannung verbinden.

3. Antriebsanordnung nach Anspruch 1 oder 2, dadurch gekennzeichnet, daß die digitalen Steuerspannungen ($\pm U_1$, $\pm U_2$, $\pm U_3$) fü4 die einzelnen Piezokristallelemente (2, 3, 4; 10) gleiche und/oder unterschiedliche Absolutbeträge haben.

4. Antriebsanordnung nach einem der Ansprüche 1 bis 3, dadurch gekennzeichnet, daß die Steuerspannungen ($\pm U_1$, $\pm U_2$, $\pm U_3$) immer die gleiche Polarität haben.

5. Antriebsanordnung nach einem oder mehreren der Ansprüche 1 bis 4, dadurch gekennzeichnet, daß die Auslenkungsbeträge der Piezokristallelemente (2, 3, 4) nach Potenzen von 2 gestaffelt sind.

6. Antriebsanordnung nach einem oder mehreren der Ansprüche 1 bis 5, dadurch gekennzeichnet, daß die Steuerspannungen ($\pm U_1$, $\pm U_2$, $\pm U_3$) an durch Isolierelemente (5, 6) getrennte sowie metallisierte Polflächen der Piezokristallelemente anlegbar sind.

7. Antriebsanordnung nach Anspruch 6, dadurch gekennzeichnet, daß die Isolierelemente (5, 6) aus Glas sind.

8. Antriebsanordnung nach Anspruch 6 oder 7, dadurch gekennzeichnet, daß die Piezokristall- (2, 3, 4) und Isolierelemente (5, 6) miteinander mit einem eitenden Kleber verklebt sind.

9. Antriebsanordnung nach einem der Ansprüche 6 bis 8, dadurch gekennzeichnet, daß der Kleber ein Zweikomponenten-Kleber ist.

10. Antriebsanordnung nach einem oder mehreren der Ansprüche 1 bis 9, dadurch gekennzeichnet, daß die Piezokristall- (32) und die Isolierelemente (31) ring- oder scheibenförmig ausgebildet sind.

11. Antriebsanordnung nach einem oder mehreren der Ansprüche 1 bis 10, dadurch gekennzeichnet, daß die piezoelektrische Antriebsanordnung in automatischen Fokussierrsystemen zur digitalisierten Steuerung einer Fokussieranordnung in geschlossenen Regelkreisen Verwendung findet.

12. Antriebsanordnung nach einem oder mehreren der Ansprüche 1 bis 10, dadurch gekennzeichnet, daß die piezoelektrische Antriebsanordnung in automatischen Fokussiersystemen zur digitalisierten Steuerung einer Fokussieranordnung in einem offenen Steuerkreis unter Benutzung eines Speichers zur Speicherung der Steuerwerte Verwendung findet.

13. Antriebsanordnung nach Anspruch 11 oder 12, dadurch gekennzeichnet, daß die piezoelektrische Antriebsanordnung zur Steuerung eines Laserstrahls für die Datenaufzeichnung auf einem oder des Datenlesen von einem rotierenden Aufzeichnungsträger Verwendung findet.

14. Antriebsanordnung nach einem oder mehreren der Ansprüche 1 bis 10, dadurch gekennzeichnet, daß die piezoelektrische Antriebsanordnung zur digitalisierten Steuerung von allgemeinen Ablenk- oder Auslenksystemen in geschlossenen Regelkreisen Verwendung findet.

15. Antriebsanordnung nach einem oder mehreren der Ansprüche 1 bis 10, dadurch gekennzeichnet, daß die piezoelektrische Antriebsanordnung zur digitalisierten Steuerung von allgemeinen Ablenk- oder Auslenksystemen in offenen Steuerkreisen unter Benutzung eins Speichers zur Speicherung der Steuerinformation Verwendung findet.

**Revendications**

1. Système d'entraînement piézo-électrique avec un circuit de commande pour la production de déviations commandés, se composant d'une pluralité d'éléments de cristal piézo-électrique pouvant être séparément sollicités par des tensions de commande électriques et disposés les uns derrière les autres, dont les déviations individuelles s'ajoutent, caractérisé en ce qu'à chaque élément de cristal piézo-électrique (2, 3, 4; 10) pour l'excitation du système d'entraînement piézo-électrique est applicable une tension de commande numérique ($\pm U_1$, $\pm U_2$, $\pm U_3$) qui est dérivée d'une tension d'entraînement ($U_{op}$) continuellement appliquée et dont la polarité, agissant sur l'élément de cristal piézo-électrique, est fixée par un décodeur conformément à un signal d'entrée logique ($\pm U_{control}$), pour piloter l'élément de cristal piézo-électrique respectif en vue d'une déviation temporairement persistante en un point extrême d'hytérésis.

2. Système d'entraînement selon la revendication 1, caractérisé en ce que le décodeur, sollicité par le signal d'entrée logique ($U_{control}$), comprend, d'une part un inverseur (18) avec un premier étage d'attaque (15) monté à la suite et, d'autre part, un second étage d'attaque (16), en ce que le signal d'entrée logique ($U_{control}$) est applicable à l'inverseur (18) et au deuxième étage d'attaque (16), et en ce que les faces polaires (12, 11) de l'élément de cristal piézo-électrique (10) sont respectivement connectées à l'un des étages d'attaque (15, 16) qui, selon la valeur du signal d'entrée logique ($U_{control}$), relient les faces de raccordement polaire d'un élément de cristal piézo-électrique à la masse ou à la tension de commande.

3. Système d'entraînement selon la revendication 1 ou 2, caractérisé en ce que les tensions de commande numériques ($\pm U_1$, $\pm U_2$, $\pm U_3$) ont, pour les divers éléments de cristal piézo-électrique (2, 3, 4; 10), des valeurs absolues égales et/ou différentes.

4. Système d'entraînement selon l'une des revendications 1 à 3, caractérisé en ce que les tensions de commande ($\pm U_1$, $\pm U_2$, $\pm U_3$) ont toujours la même polarité.

5. Système d'entraînement selon une ou plusieurs des revendications 1 à 4, caractérisé en ce que les valeurs de déviation des éléments de cristal piézo-électriques (1, 2, 3, 4) sont échelonnées suivant des puissances de 2.

6. Système d'entraînement selon une ou plusieurs des revendications 1 à 5, caractérisé en ce que les tensions de commande ($\pm U_1$, $\pm U_2$, $\pm U_3$) sont applicables à des faces polaires, séparées par des éléments isolants (5, 6) ainsi que métallisées, des éléments de cristal piézo-électrique.

7. Système d'entraînement selon la revendication 6, caractérisé en ce que les éléments isolants (5, 6) sont en verre.

8. Système d'entraînement selon la revendication 6 ou 7, caractérisé en ce que les éléments de cristal piézo-électrique (2, 3, 4) et isolants (5, 6) sont collés ensemble par une colle conductrice.

9. Système d'entraînement selon l'une des revendications 6 à 8, caractérisé en ce que la colle est une colle à deux composants.

10. Système d'entraînement selon une ou plusieurs des revendications 1 à 9, caractérisé en ce que les éléments de cristal piézo-électriques (32) et isolants (31) sont réalisés sous forme annulaire ou de disque.

11. Système d'entraînement selon une ou plusieurs des revendications 1 à 10, caractérisé en ce que le système d'entraînement piézo-électrique trouve son utilisation dans des systèmes automatiques de concentration pour la commande numérique d'un système de focalisation dans des circuits fermés de réglage.

12. Système d'entraînement selon une ou plusieurs des revendications 1 à 10, caractérisé en ce que le système d'entraînement piézo-électrique trouve son utilisation dans des systèmes automatiques de concentration pour la commande numérique d'un système de focalisation dans un circuit de commande ouvert avec emploi d'une mémoire pour l'enmagasinage des valeurs de commande.

13. Système d'entraînement selon la revendication 11 ou 12, caractérisé en ce que le système d'entraînement piézo-électrique trouve son utilisation pour la commande d'un rayon laser pour l'enregistrement de données sur ou la lecture de données d'un support d'enregistrement tournant.

14. Système d'entraînement selon une ou plusieurs des revendications 1 à 10, caractérisé en ce que le système d'entraînement piézo-électrique trouve son utilisation pour la commande numérique de systèmes généraux de déflexion ou de déviation dans des circuits fermés de régulation.

15. Système d'entraînement selon une ou plusieurs des revendications 1 à 10, caractérisé en ce que le système d'entraînement piézo-électrique trouve son utilisation pour la commande numérique de systèmes généraux de déflexion ou de déviation dans des circuits de commande ouverts avec emploi d'une mémoire pour l'enmagasinage des informations de commande.

**Claims**

1. A piezoelectric drive arrangement comprising a control circuit for effecting controlled deflections, consisting of a plurality of piezocrystal elements, which are adapted to have electric control voltages separately applied to them and are arranged one behind the other and the individual deflections of which add up, characterized in that a digital control voltage ($\pm U_1$, $\pm U_2$, $\pm U_3$) is adapted to be applied to each piezocrystal element (2, 3, 4; 10) for a control of the piezoelectric drive arrangement, and said digital control voltage is derived from a continuously applied drive voltage ($U_{ob}$) and is applied to the piezocrystal element with a polarity which is determined by a decoder in dependence on a logical input signal ($\pm U_{control}$) in order to control the respective piezocrystal element for a temporary deflection to a hysteresis end point.

2. A drive arrangement according to claim 1, characterized in that the decoder receiving the logical input signal ($U_{control}$) comprises an inverter (18), which is succeeded by a first driver stage (15) and the decoder further comprises a second driver stage (16), that the logical input signal ($U_{control}$) is adapted to be applied to the inverter (18) and to the second driver stage (16), and that the pole faces (12, 11) of the piezocrystal element (10) are connected to respective driver stages (15, 16), which in dependence on the value of the logical input signal ($U_{control}$) connect the pole faces of the piezocrystal element to ground and to the control voltage, respectively.

3. A drive arrangement according to claim 1 or 2, characterized in that the digital control voltages ($\pm U_1$, $\pm U_2$, $\pm U_3$) for the several piezocrystal elements (2, 3, 4; 10) have equal and/or different absolute values.

4. A drive arrangement according to any of claims 1 to 3, characterized in that the control voltages ($\pm U_1$, $\pm U_2$, $\pm U_3$) have always the same polarity.

5. A drive arrangement according to any of claims 1 to 4, characterized in that the amounts of the deflection of the piezocrystal elements (2, 3, 4) are binarily graded.

6. A drive arrangement according to any of claims 1 to 5, characterized in that the control voltages ($\pm U_1$, $\pm U_2$, $\pm U_3$) are adapted to be applied to the piezocrystal elements at metallized pole faces thereof, which are separated by insulating elements (5, 6).

7. A drive arrangement according to claim 6, characterized in that the insulating elements (5, 6) are made of glass.

8. A drive arrangement according to claim 6 or 7, characterized in that the piezocrystal elements (2, 3, 4) and the insulating elements (5, 6) are glued to each other by a conductive adhesive.

9. A drive arrangement according to claim 6 or any of claims 6 to 8, characterized in that the adhesive is a two-component adhesive.

10. A drive arrangement according to any of claims 1 to 9, characterized in that the piezocrystal elements (32) and the insulating elements (31) are ring- or disc-shaped.

11. A drive arrangement according to any of claims 1 to 10, characterized in that the piezoelectric drive arrangement is used in automatic focusing systems for a digital control of a focusing arrangement in closed-loop control systems.

12. A drive arrangement according to any of claims 1 to 10, characterized in that the piezoelectric drive arrangement is used in automatic focusing systems for a digital control of a focusing arrangement in an open-loop control circuit in conjunction with a memory for sorting the control data.

13. A drive arrangement according to claim 11 or 12, characterized in that the piezoelectric drive arrangement is used to control a laser beam for recording data on a record carrier or for reading data from a rotating record carrier.

14. A drive arrangement according to any of claims 1 to 10, characterized in that the piezoelectric drive arrangement is used for a digital control of general deflecting or deviating systems in closed-loop control systems.

15. A drive arrangement according to any of claims 1 to 10, characterized in that the piezoelectric drive arrangement is used for a digital control of general deflecting or deviating systems in open-loop control systems used in conjunction with a memory for storing the control information.

0017921

FIG. 1

FIG. 2

FIG. 3

FIG. 4A    FIG. 4B

FIG. 5